Europäisches Patentamt

(19) European Patent Office

Office européen des brevets

(11) Publication number: **0 036 764**
**B1**

## (12) EUROPEAN PATENT SPECIFICATION

(45) Date of publication of patent specification: **20.11.86**

(21) Application number: **81301189.7**

(22) Date of filing: **19.03.81**

(51) Int. Cl.⁴: **H 01 L 21/90,** H 01 L 21/268,
H 01 L 21/76

(54) **A semiconductor device with a V-groove insulating isolation structure and a method of manufacturing such a device.**

(30) Priority: **25.03.80 JP 38070/80**

(43) Date of publication of application:
**30.09.81 Bulletin 81/39**

(45) Publication of the grant of the patent:
**20.11.86 Bulletin 86/47**

(84) Designated Contracting States:
**DE FR GB**

(56) References cited:
**EP-A-0 030 286**
**DE-A-2 837 800**
**US-A-3 956 033**

**APPLIED PHYSICS LETTERS, vol. 34, no. 11,
June 1979, pages 737-739, New York, USA, C.P.
WU et al.: "Pulsed laser annealing of ion-
implanted polycrystalline silicon films"**

(73) Proprietor: **FUJITSU LIMITED
1015, Kamikodanaka Nakahara-ku
Kawasaki-shi Kanagawa 211 (JP)**

(72) Inventor: **Fukuda, Takeshi
1802-9-203, Nagao Takatsu-ku
Kawasaki-shi Kanagawa 213 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

This invention relates to a semiconductor device with a V-groove insulating isolation structure, and a method of manufacturing such a device, and more particularly to an insulating isolation structure, and the formation thereof, in a semiconductor device.

In the manufacture of bipolar semiconductor integrated circuit devices, efforts have been made in relation to the fabrication of isolation layers or regions in various devices with a view to increasing density of the integrated circuits by adopting insulating isolation of a V-groove structure, which has the merits of decreasing the area exclusively occupied by means given over to isolation purposes, as compared with a case in which an isolation layer is prepared in accordance with the known art, and of eliminating adverse effects on the performance of the devices, which occur when an isolation layer and functional layer of a device are arranged close to one another.

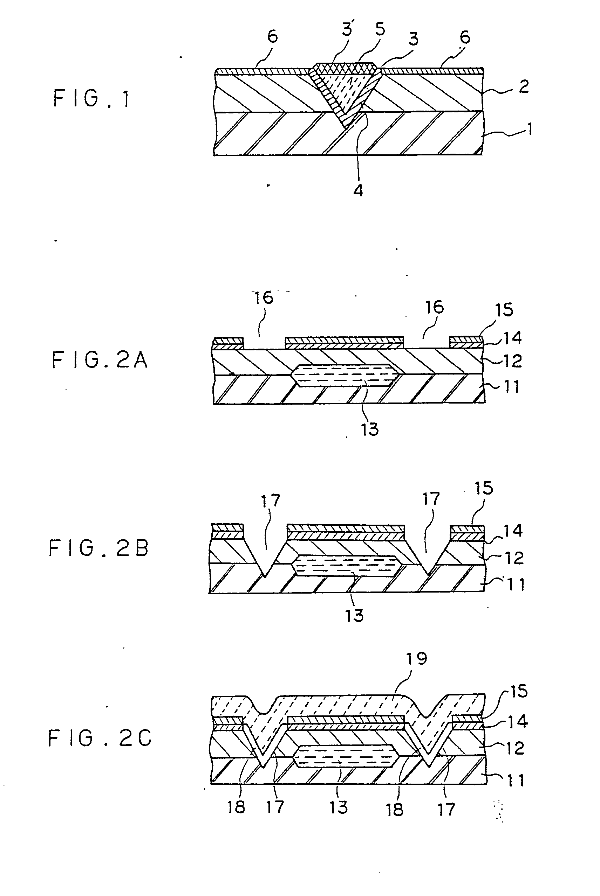

An example of a known insulating isolation V-groove structure is shown in a cross-sectional view in Figure 1 of the accompanying drawings. In a silicon substrate of a two layer structure comprising an n-type silicon epitaxial layer 2 formed on a p-type silicon substrate 1, there is formed a V-groove 4, the surface of which is covered with a silicon dioxide ($SiO_2$) film 3, which penetrates through the n-type silicon layer 2 and enters into the p-type silicon substrate 1. The V-groove is filled with high purity polycrystal silicon having a high specific resistance, and a thick silicon dioxide ($SiO_2$) film 3', which is usually 5 to 6 μm wide, is formed on the protruding surface of polycrystal silicon 5. An insulating film 6 is formed on the surface of n-type silicon layer 2.

Although this known insulating isolation layer structure is formed of polycrystal silicon the structure has been used only for the purpose of insulating isolation and for no other purposes whatsoever. Attempts were made to confer electric conductivity on the polycrystal silicon in the V-groove, which occupies considerable area of the substrate, and to utilize the insulating isolation layer structure as part of wiring layers interconnecting electrodes of a device, with a view to further increasing integration density.

However, in various methods proposed for filling the V-groove 4 of the structure as shown in Figure 1, of which the internal surface is covered with $SiO_2$ film 3, with n-type or p-type electrically conductive polycrystal silicon by means of chemical vapour-phase deposition (CVD), many technical problems have to be faced due to the facts that electrically conductive polycrystal silicon in the V-groove runs continuously throughout the entire surface of the substrate, specific resistance of the polycrystal silicon layer cannot be made too low, isolation becomes incomplete when a high electric potential is applied to the polycrystal silicon layer due to the formation of a channel in a metal-oxide-semiconductor (MOS) fashion in the p-type silicon substrate around the edge of the V-groove and the fact that $SiO_2$ film interposed between the polycrystal silicon layer and the silicon layer of the substrate is relatively thin. An attempt to positively utilize the insulating isolation layer as a wiring layer interconnecting device electrodes has not been put into practice in manufacturing bipolar integrated circuit devices. US—A— 3,956,033 discloses a semi-conductor integrated transistor device with a buried sub-collector region. The sub-collector regions is formed in a substrate on which is formed an n-type layer. A moat, having a V-groove form, is formed around a central portion of monocrystalline n-type semi-conductor material of the said n-type layer. The surface of the moat is covered with a dielectric material layer. At the bottom of the moat an opening is formed in the dielectric material layer, so that the sub-collector region is exposed at the bottom of the moat. A silicon growth process is carried out to form simultaneously, in the moat, a polycrystalline region and a single crystal extension of the sub-collector region, which latter provides a low resistance contact to the sub-collector region.

Applied Physics Letters, vol, 34, No. 11, June 1979, pages 737—739, "Pulsed laser annealing of ion implanted polycrystalline films", discusses laser and thermal annealing of such films.

According to one aspect of the present invention, there is provided a semi-conductor device having a V-groove insulating isolation structure, in which an insulating film is provided on the surface of the groove and the groove is filled with polycrystal semi-conductor containing a single crystal semi-conductor region for forming a conductive path in the groove, characterised in that the insulating film completely covers the surface of the groove.

According to another aspect of the present invention, there is provided a method of manufacturing a semi-conductor device having a V-groove isolation structure, in which an insulating film is formed on the surface of the groove, the groove is filled with polycrystal semi-conductor and a single crystal semi-conductor region, for forming a conductive path in the groove, is formed in the polycrystal semi-conductor, characterised in that the insulating film is maintained in a form completely covering the surface of the groove when the groove is filled.

In arriving at the present invention, the problems enumerated above have been fully reviewed, and a semiconductor device and a method of manufacturing the same are offered by embodiments of the present invention such that a wiring layer connecting electrodes relies upon a polycrystal silicon layer in a restricted and desired region in an insulating isolation layer of V-groove structure, the wiring layer of polycrystal silicon exhibiting excellent performance in the insulation of a device and also having a very high electric conductivity single crystal semiconductor region, with a view to improving integration density of the semiconductor device further.

A preferred semiconductor device embodying the present invention comprises:

a semiconductor substrate of a first conductivity type, a semiconductor layer of a second conductivity type, opposite to the first conductivity type, the layer being formed on the substrate, a V-groove penetrating through the semiconductor layer and into the substrate an insulating film formed on the surface of the V-groove to cover the same completely, a polycrystal semiconductor layer formed in the V-groove on the insulating film, a single crystal semiconductor region formed at a surface portion of the polycrystal semiconductor layer for forming an interconnecting path between device elements formed in the semiconductor layer, and a metal wiring layer formed in contact with the single crystal semiconductor region.

In the above semiconductor device, the polycrystal semiconductor layer preferably has a high specific resistance. Furthermore, in the above semiconductor device, the single crystal semiconductor region preferably has a first region of one conductivity type and a second region of the other conductivity type to form a PN junction therebetween, the first region being formed in the second region and forming the interconnecting path, the second region electrically isolating the first region from the polycrystal silicon layer.

A preferred method of manufacturing a semiconductor device embodying the present invention comprises the steps of:

preparing a semiconductor substrate of a first conductivity type having a semiconductor layer of a second conductivity type, opposite to the first conductivity type, the layer being formed on the substrate, forming a V-groove penetrating through the semiconductor layer and into the substrate, forming an insulating film on the surface of the V-groove to cover the same completely, forming a polycrystal semiconductor layer on the insulating film in the V-groove, and irradiating a surface portion of the polycrystal semiconductor layer with an energy beam to convert that portion to a single crystal region for an interconnecting path between device elements to be formed in the semiconductor layer.

In the above method of manufacturing a semiconductor device the energy beam may be a laser beam.

Preferably, the above method further comprises the step of implanting impurity ions in the polycrystal semiconductor layer at the said surface portion before the step of irradiating with an energy beam.

A specific method of manufacturing a semiconductor device embodying this invention comprises the steps of:

forming an isolation layer of V-groove structure, for electrically isolating device elements from one another, in a semiconductor substrate having a first semiconductor layer, of one conductivity type, which first layer has a principal face with Miller indices (100), and having a second semiconductor layer on the first semi- conductor layer, which second layer is of a conductivity type different from that of the first semiconductor layer, and has a principal face with Miller indices (100), the V-groove penetrating through the second semiconductor layer and extending into the first semiconductor layer, forming an insulating film on the internal surface of the V-groove to cover the same completely, forming a polycrystal silicon layer of high purity or of a desired electric conductivity type on the semiconductor substrate in such a manner that polycrystal silicon fills the V-groove and covers the entire surface of the substrate, removing the polycrystal silicon layer from the surface of the substrate in such a way that polycrystal silicon remains only in the V-groove,

either, selectively doping impurity material into the layer of polycrystal silicon of high purity in the V-groove to render a desired region thereof p-type or n-type in electric conductivity,

or, selectively doping impurity material into the layer of polycrystal silicon of a desired conductivity type in the V-groove to give a desired region thereof an electric conductivity of a type which is different from the said desired conductivity type, and

selectively annealing a selected region of the polycrystal silicon layer, which selected region includes that region of the polycrystal silicon layer into which the impurity material has been implanted.

Another preferred method of manufacturing a semiconductor device embodying this invention comprises the steps of:

filling the V-groove covered completely with an insulating film with polycrystal silicon of a first conductivity type to form a polycrystal silicon layer, forming in the polycrystal silicon layer a region of a second conductivity type which is different from the first conductivity type, and

annealing by laser beam to turn a desired region of the polycrystal silicon layer, including the region of the second conductivity type, into a single-crystal silicon region, thereby to form a junction between the first conductivity type and the second conductivity type in the single-crystal silicon region, the region of the second conductivity type being for interconnecting electrodes of device elements.

In a further preferred method embodying this invention, after removal of polycrystal silicon layer from the surface of the substrate to leave polycrystal silicon only in the V-groove, as mentioned above, dopant material such as boron is ion implanted into the polycrystal silicon layer in the V-groove to form a shallow p-type polycrystal silicon layer.

Reference is made, by way of example, to the accompanying drawings, in which:—

Figure 1 is a cross-sectional view illustrating an insulation isolation layer of a V-groove structure according to the prior art,

Figures 2A to 2J are cross-sectional views illustrating respective steps involved in a method embodying the present invention, and

Figures 3A to 3C are cross-sectional views illustrating respective steps involved in another method embodying the present invention.

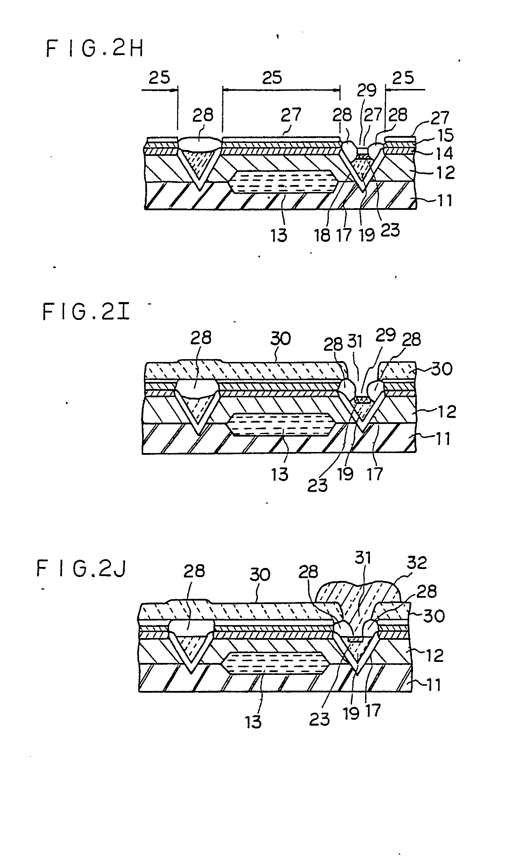

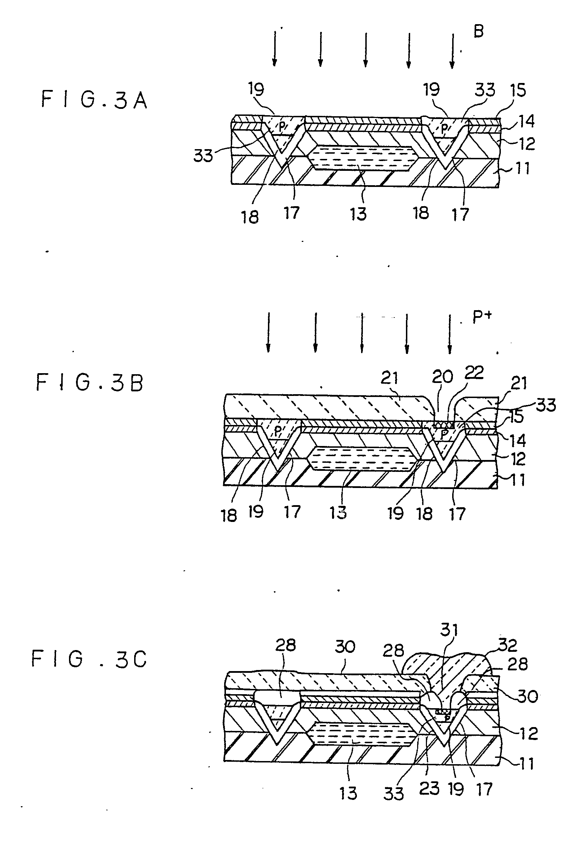

In Figures 2A to 2J and 3A to 3C like parts are designated by like reference numerals.

In a method embodying this invention and illustrated by Figures 2A to 2J, an n-type silicon layer 12 is epitaxially grown, 2 to 3 μm thick, on a p-type silicon substrate 11 with a principal surface of which the Miller indices are (100), as shown in Figure 2A, and at desired regions at the bottom of the n-type silicon layer 12, a plurality of $n^+$-type silicon buried layers 13 of a square or a rectangular shape with their sides in the directions [$\bar{1}10$] and [$1\bar{1}0$] are formed. These steps are conventional, and a silicon substrate thus formed is conventionally utilized to fabricate bipolar integrated circuits.

A first silicon dioxide ($SiO_2$) film 14 approximately 100 nm (1,000Å) thick is formed on the substrate, by a known thermal oxidation process for example, and on this first $SiO_2$ film 14, a first silicon nitride ($Si_3N_4$) film 15 approximately 250 nm (2,500Å) thick is grown, by a conventional chemical vapour-phase deposition for example. Using a known process such as photolithographic etching, a window 16 is formed as illustrated in Figure 2B in the first $Si_3N_4$ film 15 and the first $SiO_2$ film 14 under the film 15 for the purpose of subsequently forming a V-groove approximately 6 to 7 μm wide which will surround the upper regions of each buried layer 13 in the [$\bar{1}10$] and [$1\bar{1}0$] directions.

These steps are followed by anisotropic etching of the silicon layer exposed through the window 16 for forming the V-groove, using anisotropic etchant containing potassium hydroxide (KOH) for example. There is formed in the substrate at the periphery of the buried layer 13 a V-groove 17 penetrating through the n-type silicon layer 12 and reaching into the p-type silicon substrate 11.

Next, as depicted in Figure 2C, a second silicon dioxide ($SiO_2$) film 18 approximately 0.5 μm thick is formed by a known process on the internal surface of the V-groove 17. Thereafter, a high purity polycrystal silicon layer 19 approximately 6 to 7 μm thick is grown on the surface of the substrate by the conventional chemical vapour-phase deposition such that the V-groove 17 is completely filled with polycrystal silicon.

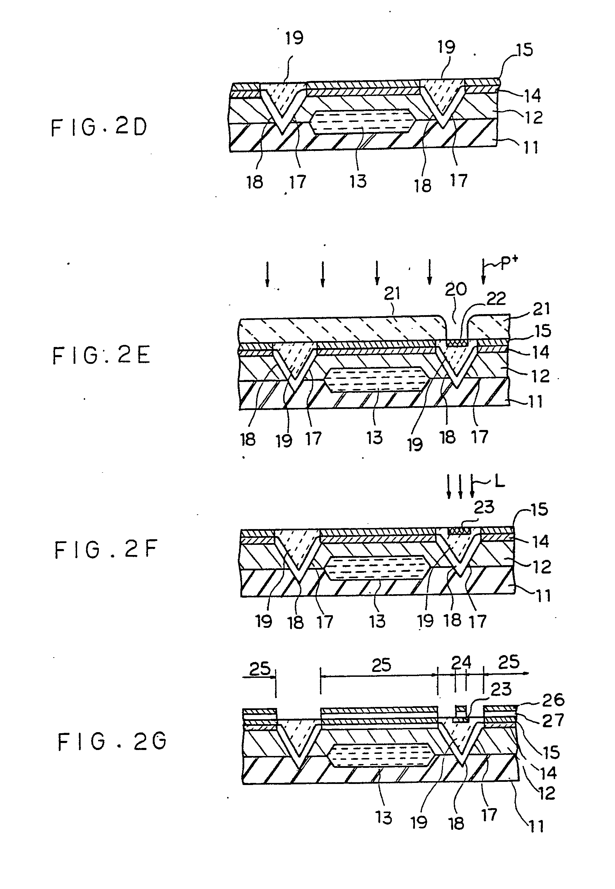

The substrate is then lapped by a known process to remove polycrystal silicon layer 19 deposited on the substrate and also, as shown in Figure 2D, to expose the $Si_3N_4$ film 15 under the layer of polycrystal silicon. Throughout these steps, polycrystal silicon layer 19 still remains in the V-groove 17.

Further, a photoresist layer 21 is coated and patterned as depicted in Figure 2E to provide a window 20 for the purpose of subsequently forming an electrically conductive layer of a desired shape. Ions of phosphorus ($P^+$) are ion implanted, with a dosage of $1\times10^{15}$ cm$^{-2}$ at an energy of 60 Kev, and the photoresist layer 21 is used as a mask to form in the polycrystal silicon layer 19 in the V-groove 17 an ion implanted layer 22 of $n^+$-type of a desired shape having a depth of approximately 0.15 μm.

Here, the photoresist layer 21 on the substrate is removed using a conventional technique, and as illustrated in Figure 2F, the ion implanted layer 22 is irradiated by a Q switch ruby laser beam L having a power density of $10^7$ to $10^8$ w/cm$^2$ for a short period of time, typically 20 to 50 ns, to anneal the layer 22 according to a given pattern to fabricate $n^+$-type single-crystal silicon conductive layer 23. Thereafter, in order to ensure the insulation of the surfaces of the conductive layer 23 and polycrystal silicon layer 19, it is desired that a fourth $SiO_2$ film 28 (see Figure 2H) which is about 1 μm thick is formed by conventional thermal oxidation on the surface of polycrystal silicon layer 19 including the conductive layer 23. As will be understood by those skilled in the art, it is not easy to form in such a thick $SiO_2$ film a window for contact to the conductive layer 23 in a later process step. Therefore, processes subsequent to the completion of the conductive layer 23 are carried out in a manner described below.

Employing a conventional chemical vapour-phase deposition technique, there is grown on the substrate a third $SiO_2$ film 27 approximately 100 nm (1,000Å) thick and a second $Si_3N_4$ film 26, also approximately 100 nm (1,000Å) thick. These films are patterned according to a conventional method, and as shown in Figure 2G an oxidation resisting mask layer is formed on a region 24 where a window is to be formed for an electrode contact to the conductive layer 23, the mask layer being comprised of the third $SiO_2$ film 27 and the second $Si_3N_4$ film 26 thereon. Throughout the process just described, the oxidation resisting mask layer remains on a region 25 of the substrate where device elements are to be fabricated.

Then, the substrate undergoes a conventional thermal oxidation to form a fourth $SiO_2$ film 28 approximately 1 μm thick on the conductive layer 23 and polycrystal silicon layer 19 where not covered by the oxidation resisting mask layer, as illustrated in Fig. 2H. Subsequent to this, the second $Si_3N_4$ film 26 is removed and a window 29 for contact to the conductive layer is formed through the thick fourth $SiO_2$ film 28 on the conductive layer 23, the thin third $SiO_2$ film 27 being left at the bottom of the window. During the above-described process, the third $SiO_2$ film 27 remains on the first $Si_3N_4$ film 15 in the region 25 where device elements are to be fabricated.

Thereafter, devices such as transistors (not shown) are fabricated in the epitaxial layer in the region 25 according to a conventional method, and as depicted in Figure 2I, the substrate is coated with an insulation layer 30 of phosphosilicate-glass (PSG) for example. Further utilizing a conventional technique, a window 31 for a wiring connection to the conductive layer 23 formed in the polycrystal layer 19 in V-groove 17 for establishing an interconnecting path between electrodes of device elements is formed simultaneously with the opening of windows (not shown) for other electrode contacts to each functional layer of semiconductor device elements fabricated through insulating protective layers 30, 27, 15 and 14.

Then, as illustrated in Figure 2J, a metal wiring layer 32 of aluminium for example is fabricated in contact with the conductive layer 23 in the contact window 31 in a manner known to the person skilled in the art.

An electrically conductive layer or wiring layer for interconnecting the electrodes of the devices, in a V-groove isolation region prepared in accordance with the method described above is formed of single-crystal silicon doped with impurity material, so that its electrical resistance is extremely low. Further, since this conductive layer is isolated from the semiconductor device element region (25) by $SiO_2$ film 18 formed on the internal surface of the V-groove and by the thick high purity polycrystal silicon layer deposited in the V-groove, it shows excellent insulation characteristics and dielectric strength vis-a-vis the device element region. Furthermore, isolation defects due to a parasitic MOS effect as experienced with conventional V-groove structure are effectively prevented by the existence of the high resistivity polycrystal silicon layer at the bottom of the V-groove in an embodiment of the invention.

In the foregoing embodiment of the invention, the V-groove is filled with high purity polycrystal silicon having a high resistance value, then an electrically conductive layer is formed in the polycrystal silicon layer at the surface thereof. In a second embodiment of this invention, however, a polycrystal silicon layer of one conductivity type is employed to fill the V-groove, and in a desired region of the polycrystal silicon layer, which region is of a first conductivity type, a polycrystal silicon region of a second conductivity type, different from the first conductivity type, is formed by means of ion implantation. Laser annealing is then carried out to turn a desired region of the polycrystal silicon layer, including the polycrystal silicon region of the second conductivity type, into a single-crystal silicon structure. By this annealing step a pn-junction is formed in the single-crystal silicon between the region of the single crystal which is of the first conductivity type, which is the same as that of the polycrystal silicon layer in the V-groove, and a conductive layer or wiring layer for interconnecting the electrodes of the device elements which is comprised of the single-crystal silicon region of the second conductivity type. High resistance value of the pn-junction in the reverse direction is utilized to ensure a high degree of insulation between the conductive layer or wiring layer for connecting the electrodes and the device region, and to prevent parasitic MOS transistor action at the bottom of the V-groove.

In a third embodiment of the invention, steps explained above with reference to Figures 2A to 2D are carried out in exactly the same manner.

Then, as illustrated in Figure 3A, dopant material, boron for example, is ion implanted by a conventional method into the polycrystal silicon layer 19 in the V-groove to form a shallow p-type polycrystal silicon layer 33.

Thereafter, photoresist is coated and patterned as shown in Figure 3B in the same manner as was explained with reference to Figure 2E to provide a window 20. Ions of phosphorus ($P^+$) are implanted with a dosage of $1 \times 10^{15}$ cm$^{-2}$ under an accelerating energy of 60 KeV, using the photoresist layer 21 as a mask to form in the polycrystal silicon layer 19 in the V-groove 17 an ion implanted layer 22 of $n^+$-type of a desired shape and having a depth of approximately 0.15 μm.

These steps are followed by those explained above with reference to Figures 2F to 2I. After a metal wiring layer 32 of aluminium for example is fabricated in the contact window 31 in a conventional manner, the structure is as illustrated in Figure 3C.

In the foregoing description of a method embodying this invention, a laser beam is used for annealing a layer implanted with ions of impurity material. As will be apparent to a person skilled in the art, an electron beam may alternatively be utilized for the annealing to attain the same result.

As will be understood from the description of embodiments of the present invention given above, a method embodying this invention makes it possible to form, at a surface portion of a V-groove, for isolation of device element regions, a wiring layer for interconnection of electrodes, which layer is of low electric resistance, without impairing the isolation characteristics of the V-groove between device elements. This contributes to increasing integration density of integrated circuits such as bipolar integrated circuits.

An embodiment of this invention provides a method of fabricating a semiconductor device having a V-groove insulating isolation structure in which the groove is filled with polycrystal silicon and the internal surface of the groove is covered with an insulating film of silicon dioxide, the method comprising selectively ion implanting an impurity material into a desired region of the polycrystal silicon layer in order to give this desired region a desired different type of electric conductivity relative to the polycrystal silicon layer, followed by selectively annealing, by an energy beam such as laser beam, a desired part of the polycrystal silicon layer including the region into which the impurity material has been ion implanted.

Thus, an embodiment of the present invention provides a semiconductor device having a V-groove insulating isolation structure, in which an insulating film is formed on the surface of the groove and the groove is filled with polycrystal semiconductor, and a selected region of the polycrystal semiconductor is annealed for forming a conductive path in the groove.

Moreover, an embodiment of the present invention provides a method of manufacturing a semiconductor device having a V-groove insulating isolation structure in which an insulating film is formed on the surface of the groove and the groove is filled with polycrystal semiconductor, and a selected region of the polycrystal semiconductor is annealed for forming a conductive path in the groove.

## Claims

1. A semi-conductor device having a V-groove insulating isolation structure, in which an insulating film (18) is provided on the surface of the groove (17) and the groove is filled with polycrystal semi-conductor (19) containing a single crystal semi-conductor region (23, 22, 33) for forming a conductive path in the groove (17), characterised in that the insulating film (18) completely covers the surface of the groove (17).

2. A semiconductor device as claimed in claim 1, wherein the single crystal semiconductor region (23; 22, 33) is formed by annealing.

3. A semiconductor device as claimed in claim 1 or 2, comprising a semiconductor substrate (11) of a first conductivity type, a semiconductor layer (12) of a second conductivity type, opposite to the first conductivity type, the semiconductor layer (12) being formed on the semiconductor substrate (11), the V-groove (17) penetrating through the semiconductor layer (12) and reaching into the semiconductor substrate (11), the single crystal semiconductor region (23; 22, 33) being formed at a surface portion of the polycrystal semiconductor (19) for forming an interconnecting path between device elements formed in the semiconductor layer (12), and a metal wiring layer (32) being formed in contact with the single crystal semiconductor region (23; 22, 33).

4. A semiconductor device as claimed in claim 1, 2 or 3, wherein the polycrystal semiconductor (19) has a high specific resistance.

5. A semiconductor device as claimed in claim 1, 2, 3 or 4, wherein the single-crystal semiconductor region (22, 33) has a first region (22) of one conductivity type and a second region (33) of the other other conductivity type, forming a PN junction therebetween, the first region (22) being formed in the second region (33) and forming the said conductive path, the second region (33) electrically isolating the first region (22) from the polycrystal semiconductor (19).

6. A method of manufacturing a semiconductor device having a V-groove isolation structure, in which an insulating film (18) is formed on the surface of the groove (17), the groove (17) is filled with polycrystal semiconductor (19) and a single crystal semiconductor region (23, 22, 33), for forming a conductive path in the groove (17), is formed in the polycrystal semi-conductor (19), characterised in that the insulating film (18) is maintained in a form completely covering the surface of the groove (17) when the groove is filled.

7. A method as claimed in claim 6, wherein the single crystal semiconductor region (23; 22, 33) is formed by annealing.

8. A method as claimed in claim 6 or 7, comprising:

preparing a semiconductor substrate (11) of a first conductivity type, having thereon a semiconductor layer (12) of a second conductivity type, opposite to the first conductivity type, forming the V-groove (17) to penetrate through the semiconductor layer (12) into the substrate (11), and

irradiating a surface portion of the polycrystal semiconductor (19) with an energy beam to convert that surface portion to the single crystal semiconductor region (23; 22, 33) for forming an interconnecting path between device elements to be formed in the semiconductor layer (12).

9. A method as claimed in claim 8, wherein the energy beam is a laser beam.

10. A method as claimed in claim 8 or 9, further comprising implanting impurity ions into the polycrystal semiconductor (19) at the said surface portion thereof, before irradiation with the energy beam.

## Patentansprüche

1. Halbleitervorrichtung mit isolierender V-Nut-Isolationsstruktur, bei welcher ein isolierender Film (18) auf der Oberfläche der Nut vorgesehen ist und die Nut mit polykristallinem Halbleiter (19) gefüllt ist, der einen Einkristall-Halbleiterbereich (23; 22, 33) enthält, um einen leitenden Weg in der Nut (17) zu bilden, dadurch gekennzeichnet, daß der isolierende Film (18) vollständig die Oberfläche der Nut (17) bedeckt.

2. Halbleitervorrichtung nach Anspruch 1, bei welcher der Einkristall-Halbleiterbereich (23; 22, 33) durch Anneal-Behandlung gebildet ist.

3. Halbleitervorrichtung nach Anspruch 1 oder 2, mit einem Halbleitersubstrat (11) von einem ersten Leitfähigkeitstyp, einer Halbleiterschicht (12) von einem zweiten Leitfähigkeitstyp, der entgegengesetzt zum ersten Leitfähigkeitstyp ist, wobei die Halbleiterschicht (12) auf dem Substrat (11) gebildet ist, die V-Nut (17) durch die Halbleiterschicht (12) hindurchdringt und in das Halbleitersubstrat (11) hineinreicht, der Einkristall-Halbleiterbereich (23; 22, 33) an einem Oberflächenabschnitt der polykristallinen Halbleiters (19) gebildet ist, um einen Verbindungsweg zwischen den Vorrichtungselementen zu bilden, die in der Halbleiterschicht (12) gebildet sind, und eine Metallverdrahtung (32) in Kontakt mit dem Einkristall-Halbleiterbereich (23; 22, 33) gebildet ist.

4. Halbleitervorrichtung nach Anspruch 1, 2 oder 3, bei welcher der polykristalline Halbleiter (19) einen hohen spezifischen Widerstand hat.

5. Halbleitervorrichtung nach Anspruch 1, 2, 3 oder 4, bei welcher der Einkristall-Halbleiterbereich (22, 33) einen ersten Bereich (22) von einem ersten Leitfähigkeitstyp und einen zweiten Bereich (33) von dem anderen Leitfähigkeitstyp hat, zwischen denen ein PN-Übergang gebildet wird, wobei der erste Bereich (22) in dem zweiten Bereich (33) gebildet ist und den genannten leitenden Weg bildet, und der zweite Bereich (33) den ersten Bereich (22) elektrisch von dem polykristallinen Halbleiter (19) isoliert.

6. Verfahren zur Herstellung einer ßalbleitervorrichtung mit einer V-Nut-Isolationsstruktur, bei welchem ein isolierender Film (18) auf der Oberfläche der Nut (17) gebildet wird, die Nut (17) mit polykristallinem Halbleiter (19) gefüllt wird und ein Einkristall-Halbleiterbereich (23, 22, 33), um einen leitenden Weg in der Nut (17) zu bilden, in dem polykristallinen Halbleiter (19) gebildet wird, dadurch gekennzeichnet, daß der isolierende Film (18) in einer, die Oberfläche der Nut (17) vollständig bedeckenden Form gehalten wird, wenn die Nut gefüllt wird.

7. Verfahren nach Anspruch 6, bei welchem der Einkristall-Halbleiterbereich (23; 22, 33) durch Anneal-Behandlung gebildet wird.

8. Verfahren nach Anspruch 6 oder 7, mit:

Herstellung eines Halbleitersubstrats (11) von einem ersten Leitfähigkeitstyp, welcher eine Halbleiterschicht (12) von einem zweiten Leitfähigkeitstyp, der zu dem ersten Leitfähigkeitstyp entgegengesetzt ist, trägt,

Bildung der V-Nut (17), um durch die Halbleiterschicht (1/) hindurch in das Substrat (11) einzudringen, und

Bestrahlung eines Oberflächenabschnitts des polykristallinen Halbleiters (19) mit einem Energiestrahl, um diesen Oberflächenabschnitt in einen Einkristall-Halbleiterbereich (23; 22, 33) umzufandeln, um einen Verbindungsweg zwischen den Vorrichtungselementen zu bilden, die in der Halbleiterschicht (12) gebildet werden sollen.

9. Verfahren nach Anspruch 8, bei welchem der Energiestrahl ein Laserstrahl ist.

10. Verfahren nach Anspruch 8 oder 9, ferner mit Implantation von Verunreinigungsionen in den polykristallinen Halbleiter (19) an dem genannten Oberflächenabschnitt desselben, vor Bestrahlung mit dem Energiestrahl.

**Revendications**

1. Dispositif semiconducteur possédant une structure d'isolation isolante à rainure en V, dans laquelle une pellicule isolante (18) est disposée à la surface de la rainure (17) et la rainure est remplie d'un matériau semiconducteur polycristallin (19) contenant une région semiconductrice monocristalline (23, 22, 33) destinée à former un trajet conducteur dans la rainure (17), caractérisé en ce que la pellicule isolante (18) couvre complètement la surface de la rainure (17).

2. Dispositif semiconducteur selon la revendication 1, où la région semiconductrice monocristalline (23; 22, 33) est formée par recuit.

3. Dispositif semiconducteur selon la revendication 1 ou 2, comprenant un substrat semiconducteur (11) d'un premier type de conductivité, une couche semiconductrice (12) d'un deuxième type de conductivité, opposé au premier type de conductivité, la couche semiconductrice (12) étant formée sur le substrat semiconducteur (11), la rainure en V (17) pénétrant dans la couche semiconductrice (12) et atteignant le substrat semiconducteur (11), la région semiconductrice monocristalline (23; 22, 33) étant formée au niveau d'une partie de surface du matériau semiconducteur polycristallin (19) afin de former un trajet d'interconnexion entre des éléments de dispositif formés dans la couche semiconductrice (12), et une couche de câblage métallique (32) étant formée en contact avec la région semiconductrice monocristalline (23; 22, 33).

4. Dispositif semiconducteur selon la revendication 1, 2 ou 3, où le matériau semiconducteur polycristallin (19) possède une résistance spécifique élevée.

5. Dispositif semiconducteur selon la revendication 1, 2, 3 ou 4, où la région semiconductrice monocristalline (22, 33) possède une première région (22) d'un premier type de conductivité et une deuxième région (33) de l'autre typs de conductivité, formant entre elles une jonction pn, la première région (22) étant formée dans la deuxième région (33) et formant ledit trajet conducteur, la deuxième région (33) isolant électriquement la première région (22) vis-à-vis du matériau semiconducteur polycristallin (19).

6. Procédé de fabrication d'un dispositif semiconducteur possédant une structure d'isolation à rainure en V, où on forme une pellicule isolante (18) à la surface de la rainure (17), on remplit la rainure (17) à l'aide d'un matériau semiconducteur polycristallin (19), et on forme dans le matériau semiconducteur polycristallin (19) une région semiconductrice monocristalline (23, 22, 33) afin de former un trajet conducteur dans la rainure (17), caractérisé en ce qu'on maintient la pellicule isolante (18) sous une forme couvrant complètement la surface de la rainure (17) lorsque la rainure est remplie.

7. Procédé selon la revendication 6, où la région semiconductrice monocristalline (23; 22, 33) est formée par recuit.

8. Procédé selon la revendication 6 ou 7, comprenant les opérations suivantes:

préparer un substrat semiconducteur (11) d'un premier type de conductivité, portant une couche semiconductrice (12) d'un deuxième type de conductivité, opposé au premier type de conductivité,

former la rainure en V (17) afin qu'elle pénètre dans la couche semiconductrice (12) jusqu'au substrat (11),

irradier une partie de surface du matériau semiconducteur polycristallin (19) à l'aide d'un faisceau d'énergie pour transformer cette partie de surface en la région semiconductrice monocristalline (23; 22, 33) afin de former un trajet d'interconnexion entre des éléments de dispositif à former dans la couche semiconductrice (12).

9. Procédé selon la revendication 8, où le faisceau d'énergie est un faisceau laser.

13 0 036 764 14

10. Procédé selon la revendication 8 ou 9, comprenant en outre l'opération qui consiste à implanter des ions d'impureté dans le matériau semiconducteur polycristallin (19) au niveau de sa dite partie de surface, avant l'irradiation par le faisceau d'énergie.

FIG.1

FIG.2A

FIG.2B

FIG.2C

FIG.2D

FIG.2E

FIG.2F

FIG.2G

FIG.2H

FIG.2I

FIG.2J

F I G . 3 A

B

19          19    33   15
33                              14
                                12
                                11
18    17    13    18    17

F I G . 3 B

P+

21      20  22  21
                        33
                        15
                        14
                        12
                        11
18  19  17    13    19  18  17

F I G . 3 C

28    30    28    31    32
                              28
                              30
                              12
                              11
13    33    23  19  17

4